# EUROPÄISCHE PATENTSCHRIFT

(11) **EP 3 766 214 B1**
(45) Veröffentlichungstag und Bekanntmachung des Hinweises auf die Patenterteilung: **07.09.2022**
(21) Anmeldenummer: 19709442.8
(22) Anmeldetag: 05.03.2019
(51) Int. Cl.: H04L 12/40

(54) **TEILNEHMERSTATION FÜR EIN SERIELLES BUSSYSTEM UND VERFAHREN ZUR DATENÜBERTRAGUNG IN EINEM SERIELLEN BUSSYSTEM**
SUBSCRIBER STATION FOR A SERIAL BUS SYSTEM, AND METHOD FOR DATA TRANSMISSION IN A SERIAL BUS SYSTEM
STATION D'ABONNÉ POUR UN SYSTÈME DE BUS SÉRIE ET PROCÉDÉ DE TRANSMISSION DE DONNÉES DANS UN SYSTÈME DE BUS SÉRIE

(30) Priorität: 12.03.2018 DE 102018203705
(43) Veröffentlichungstag der Anmeldung: 20.01.2021
(73) Patentinhaber: Robert Bosch GmbH, 70442 Stuttgart (DE)
(72) Erfinder: HUEBL, Jochen, 71701 Schwieberdingen (DE); WALKER, Steffen, 72770 Reutlingen (DE); WEISSENMAYER, Simon, 74223 Flein (DE)
(86) Internationale Anmeldenummer: PCT/EP2019/055363
(87) Internationale Veröffentlichungsnummer: WO 2019/174958

(56) Entgegenhaltungen:
- DE-A1-102014 204 048
- US-A1- 2011 188 371
- US-A1- 2015 220 401

## Beschreibung

### Technisches Gebiet

Die vorliegende Erfindung betrifft eine Teilnehmerstation für ein serielles Bussystem und ein Verfahren zur Datenübertragung in einem seriellen Bussystem, bei welchem eine Diagnose von Störungen im Bussystem, wie beispielsweise in Bezug auf EMV durchführbar ist und Strategien auf Systemebene ermittelt und angewendet werden.

### Stand der Technik

Die US 2015/220401 A1 offenbart ein System und ein Verfahren zum Bestimmen, wann ein Controller in Antwort auf einen Bus-Off Zustand zurückzusetzen ist.

Die US 2011 /188371 A1 beschreibt ein Verfahren zum Erkennen eines fehlerhaften Knotens, der an einen Bus angeschlossen ist,
wobei der Knoten in einem normalen Betriebszustand bei Erkennung eines Fehlers einen internen Fehlerzähler inkrementiert.

CAN-Bussysteme sind beispielsweise in Fahrzeugen oder in industriellen Anlagen zur Kommunikation zwischen Steuergeräten vorgesehen. In CAN-Bussystemen werden Nachrichten mittels des CAN- und/oder CAN FD Protokolls übertragen, wie es in der derzeitigen ISO11898-1:2015 als CAN Protokoll-Spezifikation mit CAN FD beschrieben ist. Zudem ist als weitere Abwandlung von CAN oder CAN FD ein LVCAN bekannt, bei welchem die Nachrichten zumindest teilweise mit einem Sendepegel gesendet werden, indem die Spannungsversorgung gegenüber dem üblichen Pegel von 5V reduziert ist, insbesondere auf 3, 5 V.

Die Kommunikation im Bussystem läuft in der Regel in Echtzeit ab. Dadurch können über das Bussystem auch sicherheitsrelevante Daten versendet werden, die gegebenenfalls eine schnelle Reaktion eines Steuergeräts oder von Aktoren erfordern, die von dem Steuergerät gesteuert sind.

Im Betrieb eines Fahrzeugs oder einer industriellen Anlage können jedoch aufgrund von bestimmten Ereignissen Störungen in der Kommunikation im Bussystem auftreten. Als Lösung dafür werden von den Teilnehmerstationen Fehler bei Senden und beim Empfang gezählt. Hierbei werden in einem CAN-Bussystem Sendefehler höher bewertet als Empfangsfehler.

Wenn mindestens ein Fehlerzähler einen Wert von 127 überschreitet, geht die Teilnehmerstation in den Fehlerpassiv-Zustand über. Im Fehlerpassiv-Zustand werden Fehler nur noch mit rezessivem Pegel signalisiert. Außerdem muss die fehlerpassive Teilnehmerstation beim Senden von Nachrichten eine zusätzliche Wartezeit von 8 Bitzeiten einhalten. Wenn der Sendefehlerzähler 255 überschreitet wird ein Bus-Off-Zustand eingeleitet, in welchem die Teilnehmerstation bis zum nächsten Rücksetzen bzw. Reset nicht mehr am Busgeschehen teilnimmt.

Bei Fahrzeugen wird mittlerweile die Verbindung aller Geräte mit dem Internet (loT) gefordert. Dadurch werden zunehmend niederpriore Daten über den Bus des CAN-Bussystems gesendet, um diese Daten zu einem späteren Zeitpunkt auswerten zu können.

Problematisch ist jedoch, dass niederpriore Daten ebenfalls dazu führen können, dass die Fehlerzähler hochgezählt werden und dadurch eine Teilnehmerstation schneller in den Bus-Off-Zustand übergeht. Noch dazu können die niederprioren Daten unter Bedingungen, bei denen die Bandbreite eingeschränkt werden muss, die Echtzeitfähigkeit des CAN-Bussystems gefährden können.

### Offenbarung der Erfindung

Daher ist es Aufgabe der vorliegenden Erfindung, eine Teilnehmerstation für ein Bussystem und ein Verfahren zur Datenübertragung in einem Bussystem bereitzustellen, welche die zuvor genannten Probleme lösen. Insbesondere sollen eine Teilnehmerstation für ein Bussystem und ein Verfahren zur Datenübertragung in einem Bussystem bereitgestellt werden, bei welchen Bedingungen frühzeitiger erkannt und angemessen darauf reagiert werden kann, welche die Echtzeitfähigkeit des CAN-Bussystems gefährden.

Die Aufgabe wird durch eine Teilnehmerstation für ein serielles Bussystem mit den Merkmalen des Anspruchs 1 gelöst. Die Teilnehmerstation umfasst eine Kommunikationssteuereinrichtung zur Steuerung einer Kommunikation mit mindestens einer weiteren Teilnehmerstation des Bussystems, eine Sende-/Empfangseinrichtung zum Empfangen einer Nachricht von einem Bus des Bussystems, die von der Kommunikationssteuereinrichtung oder der mindestens einen weiteren Teilnehmerstation des Bussystems erstellt wurde und auf dem Bus übertragen wird, eine Störungserkennungseinheit, die ausgestaltet ist zur Erkennung einer Störung beim Übertragen der Nachricht auf dem Bus, und einer Störungsbehandlungseinheit, die ausgestaltet ist zur Auswertung der von der Störungserkennungseinheit erkannten Störung in Bezug auf Art und Größe der Störung und zur Anpassung der Steuerung der Kommunikation der Kommunikationssteuereinrichtung an das Ergebnis der Auswertung der Störung.

Durch die Messung der Störungen auf dem Bus bzw. der Einhaltung der elektromagnetischen Verträglichkeit (EMV) durch die Teilnehmerstation können kritische Buszustände verursacht durch z.B. Strahlungen in Bezug auf EMV vor dem Auftreten der ersten Störungen erkannt werden und darauf reagiert werden. Beispielsweise sind die Ergebnisse der Messung für ein Früh-Warnsystem z.B. in sicherheitskritischen Systemen wie einem Kraftfahrzeug oder Industrieanlagen einsetzbar. Die elektromagnetische Verträglichkeit (EMV) bestimmt die Fähigkeit der Teilnehmerstation, andere Teilnehmerstationen des Bussystems nicht durch ungewollte elektrische oder elektromagnetische Effekte zu stören oder durch andere Teilnehmerstationen gestört zu werden.

Mit der Teilnehmerstation können somit Störungen frühzeitiger erkannt werden. Als Folge davon ist das Bussystem robuster gegenüber kurzzeitigen EMV-Störungen, weil sich die Kommunikation besser an geänderte Umgebungsbedingungen anpassen kann. Die Teilnehmerstation kann hierfür aufgrund der Messergebnisse Kommunikationsstrategien zu anderen Teilnehmerstationen des Bussystems, insbesondere zu Steuergeräten, ändern. Setzen mehrere Steuergeräte diese Technik ein, oder kann eine der Teilnehmerstationen die Störungen für die einzelnen Teilnehmerstationen separate erkennen, so ist eine Lokalisierung von Störungen im Netzwerk möglich. Dadurch sind ein optimaler Betrieb und eine leichtere und kostengünstigere Reparatur des Bussystems möglich.

Vorteilhafte weitere Ausgestaltungen der Teilnehmerstation sind in den abhängigen Ansprüchen angegeben.

Möglicherweise ist die Störungsbehandlungseinheit ausgestaltet, zwischen äußerer und innerer Störung der Übertragung der Nachricht auf dem Bus zu unterscheiden.

In einer Ausgestaltung kann die Störungserkennungseinheit ein Einzelpegelüberwachungsmodul zur Überwachung von Einzelpegeln von differenziellen Bussignalen aufweisen. Zusätzlich oder alternativ kann die Störungserkennungseinheit ein Differenzspannung-Überwachungsmodul zur Überwachung aufweisen, ob eine differenzielle Spannung außerhalb eines vorbestimmten Bereichs liegt. Zusätzlich oder alternativ kann die Störungserkennungseinheit ein Gleichtaktstörung-Überwachungsmodul zur Überwachung aufweisen, ob die durchschnittliche Spannung aus den differenziellen Bussignalen schneller als vorbestimmt oder für eine vorbestimmte Zeit von einem vorbestimmten Wert abweicht. Zusätzlich oder alternativ kann die Störungserkennungseinheit ein Bandstörung-Überwachungsmodul zur Überwachung von vorbestimmten Frequenzbereichen der oben genannten Signale aufweisen.

Hierbei ist es möglich, dass das Einzelpegelüberwachungsmodul ausgestaltet ist zu überwachen, ob sich einer der Pegel besonders schnell ändert und/oder über längere Zeit von einem vorbestimmten Bereich abweicht, und/oder wobei das Einzelpegelüberwachungsmodul ausgestaltet ist zu überwachen, ob einer der Pegel so hoch ist, dass eine Begrenzung durch interne Schutzdioden wegen elektrostatischer Entladung oder ein hoher Gleichtakt verursacht durch EMV-Einkopplung nicht ausgeschlossen werden kann.

Es ist denkbar, dass das Differenzspannung-Überwachungsmodul ausgestaltet ist zu überwachen, ob sich das Signal der differenziellen Spannung ungewöhnlich schnell oder ungewöhnlich langsam ändert, und/oder wobei das Differenzspannung-Überwachungsmodul ausgestaltet ist zu überwachen, ob sich das Signal der differenziellen Spannung über eine vorbestimmte Zeit ungewöhnlich nahe an einer in der Sende-/Empfangseinrichtung eingestellten Entscheidungsschwelle bewegt, mit welcher die Sende-/Empfangseinrichtung ausgestaltet ist zu entscheiden, ob das Signal der differenziellen Spannung einem rezessiven Buszustand oder einem dominanten Buszustand entspricht.

Möglicherweise hat das Bandstörung-Überwachungsmodul ein Filter, um die bestimmten Frequenzbereiche herauszugreifen, wobei das Filter mindestens ein Bandpass und/oder mindestens eine Hochfrequenz-Gleichrichterschaltung ist und das Filter an seinem Ausgang mit mindestens einem Analog-Digital-Wandler verbunden ist.

Gemäß einer Ausgestaltung kann die Störungsbehandlungseinheit ausgestaltet sein, die Steuerung der Kommunikation der Kommunikationssteuereinrichtung durch mindestens eine der nachfolgenden Maßnahmen anzupassen, nämlich Mitteilen der Störung mit einer Nachricht an mindestens eine der anderen Teilnehmerstationen im Bussystem, und/oder Verzicht auf das Versenden niederpriorer Nachrichten, und/oder Senden von sicherheitsrelevanten Nachrichten redundant über einen weiteren Kommunikationskanal oder zeitlich versetzt, und/oder Anpassen mindestens eines Bit-Timing-Parameters für die Nachricht abhängig von der erkannten Störung, und/oder nicht Erhöhen der Datenrate nach der Arbitrierungsphase für eine CAN-FD-Nachricht, obwohl ein Fehlerzähler noch nicht die normalerweise dazu erforderliche Schwelle erreicht hat, und/oder nicht Reduzieren der maximalen Amplitude der Differenzspannung für eine LVCAN-Nachricht und damit nicht Erhöhen der Datenrate, obwohl ein Fehlerzähler noch nicht die dazu erforderliche vorbestimmte Schwelle erreicht hat.

Gemäß einem Ausführungsbeispiel ist die Störungsbehandlungseinheit ausgestaltet, die Störung mit einer Nachricht mindestens einem Sensor mitzuteilen, der mit der Teilnehmerstation verbunden ist.

Gemäß einem Ausführungsbeispiel hat die Teilnehmerstation zudem einen Fehlerzähler, der ausgestaltet ist, für jede Teilnehmerstation des Bussystems die mindestens eine Störung separat aufzusummieren, die durch das Senden der Nachricht mit der Sende-/Empfangseinrichtung entsteht.

Die zuvor beschriebene Teilnehmerstation kann Teil eines Bussystems sein, das zudem einen Bus umfasst, über welchen mindestens zwei Teilnehmerstationen derart miteinander verbunden sind, dass sie miteinander kommunizieren können. Hierbei können die mindestens zwei Teilnehmerstationen ausgestaltet sein, Daten über die Störung an eine Zentrale zur Verwendung in einer Karte zu senden, welche die der Störung entsprechende EMV-Belastung geographisch darstellt.

Die zuvor genannte Aufgabe wird zudem durch ein Verfahren zur Datenübertragung in einem seriellen Bussystem nach Anspruch 13 gelöst. Bei dem Verfahren sind in dem Bussystem mindestens zwei Teilnehmerstation über einen Bus derart miteinander verbunden, dass sie miteinander kommunizieren können. Das Verfahren weist die Schritte auf: seriell Empfangen, mit einer Sende-/Empfangseinrichtung einer der Teilnehmerstationen, einer Nachricht von dem Bus, die von einer Kommunikationssteuereinrichtung der Teilnehmerstation oder der mindestens einen weiteren Teilnehmerstation des Bussystems erstellt wurde und auf dem Bus übertragen wird, Erkennen, mit einer Störungserkennungseinheit, einer Störung beim Übertragen der Nachricht auf dem Bus, Auswerten, mit einer Störungsbehandlungseinheit, der von der Störungserkennungseinheit erkannten Störung in Bezug auf Art und Größe der Störung, und Anpassen einer Steuerung der Kommunikation der Kommunikationssteuereinrichtung an das Ergebnis der Auswertung der Störung.

Das Verfahren bietet dieselben Vorteile, wie sie zuvor in Bezug auf die Teilnehmerstation genannt sind.

Weitere mögliche Implementierungen der Erfindung umfassen auch nicht explizit genannte Kombinationen von zuvor oder im Folgenden bezüglich der Ausführungsbeispiele beschriebenen Merkmale oder Ausführungsformen. Dabei wird der Fachmann auch Einzelaspekte als Verbesserungen oder Ergänzungen zu der jeweiligen Grundform der Erfindung hinzufügen.

### Zeichnungen

Nachfolgend ist die Erfindung unter Bezugnahme auf die beiliegende Zeichnung und anhand von Ausführungsbeispielen näher beschrieben. Es zeigen:
Fig. 1 ein vereinfachtes Blockschaltbild eines Bussystems gemäß einem ersten Ausführungsbeispiel;
Fig. 2 ein Schaubild zur Veranschaulichung eines Aufbaus von Nachrichten, die von einer Teilnehmerstation des Bussystems gemäß dem ersten Ausführungsbeispiel gesendet werden können;
Fig. 3 eine Darstellung eines Beispiels für einen zeitlichen Spannungsverlauf von differentiellen Bussignalen für eine Nachricht, die auf einem Bus des Bussystems gemäß einem ersten Ausführungsbeispiel gesendet wird;
Fig. 4 eine Darstellung eines Spannungsverlaufs der differentiellen Spannung, die aus dem zeitlichen Spannungsverlauf der differentiellen Bussignale von Fig. 2 resultiert;
Fig. 5 ein vereinfachtes Blockschaltbild mit einer Störungsüberwachungseinheit einer Teilnehmerstation des Bussystems gemäß dem ersten Ausführungsbeispiel;
Fig. 6 ein vereinfachtes Blockschaltbild eines Fehlerzählers einer Teilnehmerstation des Bussystems gemäß einem zweiten Ausführungsbeispiel;
Fig. 7 ein vereinfachtes Blockschaltbild eines Bussystems mit einem System gemäß einem dritten Ausführungsbeispiel; und
Fig. 8 ein vereinfachtes Blockschaltbild eines Bussystems mit einem System gemäß einem vierten Ausführungsbeispiel.

In den Figuren sind gleiche oder funktionsgleiche Elemente, sofern nichts Anderes angegeben ist, mit denselben Bezugszeichen versehen.

### Beschreibung der Ausführungsbeispiele

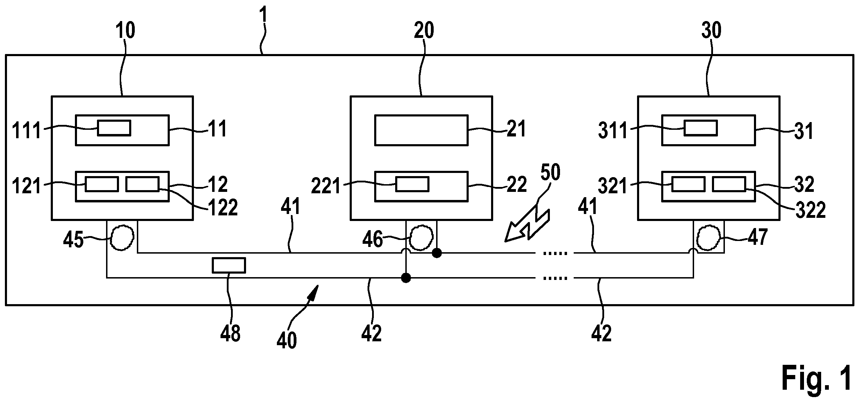

Fig. 1 zeigt ein Bussystem 1 zur seriellen Übertragung von Daten. Das Bussystem 1 ist beispielsweise ein CAN-Bussystem und/oder ein CAN FD-Bussystem und/oder ein LVCAN-Bussystem, usw. Das Bussystem 1 kann in einem Fahrzeug, insbesondere einem Kraftfahrzeug, einem Flugzeug, usw., oder im Krankenhaus usw. Verwendung finden. Das Bussystem 1 ist jedoch nicht auf ein auf den genannten Varianten von CAN basierendes Bussystem beschränkt.

In Fig. 1 hat das Bussystem 1 eine Vielzahl von Teilnehmerstationen 10, 20, 30, die jeweils an einen Bus 40 mit einer ersten Busader 41 und einer zweiten Busader 42 angeschlossen sind. Die Busadern 41, 42 können auch CAN_H und CAN_L genannt werden und dienen zur Einkopplung der dominanten Pegel im Sendezustand. Über den Bus 40 sind Nachrichten 45, 46, 47 in der Form von Signalen zwischen den einzelnen Teilnehmerstationen 10, 20, 30 übertragbar. Dadurch sind Daten, die von einer der Teilnehmerstationen 10, 20, 30 an mindestens eine andere der Teilnehmerstationen 10, 20, 30 zu übertragen sind, in Signale auf dem Bus 40 umwandelbar. Die Nachricht 45 ist beispielsweise eine Nachricht mit normaler Priorität. Die Nachricht 46 ist beispielsweise eine Nachricht mit geringer Priorität, die auch als niederpriore Nachricht bezeichnet wird. Die Nachricht 47 ist beispielsweise eine Nachricht mit hoher Sicherheitsrelevanz bzw. mit hoher Priorität, die auch als hochpriore Nachricht bezeichnet wird. Erkennt eine der Teilnehmerstationen 10, 20, 30 in der Kommunikation auf dem Bus 40 einen Fehler, sendet diese Teilnehmerstation 10, 20, 30 eine Fehlernachricht 48 auf den Bus 40, die von den anderen Teilnehmerstationen 10, 20, 30 empfangen wird. Der Fehler kann beispielsweise aufgrund einer Störung 50 der Übertragung einer der Nachrichten 45, 46, 47 auf dem Bus 40 auftreten.

Die Teilnehmerstationen 10, 20, 30 sind beispielsweise Steuergeräte oder Anzeigevorrichtungen oder Sensoren oder Aktoren eines Kraftfahrzeugs oder einer industriellen Anlage oder Ähnliches.

Wie in Fig. 1 gezeigt, hat die Teilnehmerstation 10 eine Kommunikationssteuereinrichtung 11, die eine Störungsbehandlungseinheit 111 aufweist, und eine Sende-/Empfangseinrichtung 12, die einen Fehlerzähler 121 und eine Störungserkennungseinheit 122 aufweist. Die Teilnehmerstation 20 hat eine Kommunikationssteuereinrichtung 21 und eine Sende-/Empfangseinrichtung 22 mit einem Fehlerzähler 221. Die Teilnehmerstation 30 hat eine Kommunikationssteuereinrichtung 31, die eine Störungsbehandlungseinheit 311 aufweist, und eine Sende-/Empfangseinrichtung 32 mit einem Fehlerzähler 321 und einer Störungserkennungseinheit 322.

Die Sende-/Empfangseinrichtungen 12, 22, 32 der Teilnehmerstationen 10, 20, 30 sind jeweils direkt an den Bus 40 angeschlossen, auch wenn dies in Fig. 1 nicht dargestellt ist.

Die Kommunikationssteuereinrichtungen 11, 21, 31 dienen jeweils zur Steuerung einer Kommunikation der jeweiligen Teilnehmerstation 10, 20, 30 über den Bus 40 mit einer anderen Teilnehmerstation der an den Bus 40 angeschlossenen Teilnehmerstationen 10, 20, 30. Die Kommunikationssteuereinrichtungen 11, 31 sind bis auf die Störungsbehandlungseinheiten 111, 311 wie ein herkömmlicher CAN-Controller und/oder CAN FD-Controller und/oder LVCAN- Controller ausführbar. Die Kommunikationssteuereinrichtungen 21 ist wie ein herkömmlicher CAN-Controller und/oder CAN FD-Controller und/oder LVCAN-Controller ausführbar.

Die Sende-/Empfangseinrichtungen 12, 32 dienen zum Senden der jeweiligen Nachrichten 45, 46, 47. Die Sende-/Empfangseinrichtung 22 dient ebenfalls zum Senden einer der Nachrichten 45, 46, 47. Die Fehlerzähler 121, 221, 321 dienen zum Zählen der Fehler, welche die zugehörige Sende-/Empfangseinrichtung 12, 22, 32 bei der Kommunikation auf dem Bus 40 erkannt hat. Die Sende-/Empfangseinrichtungen 12, 22, 32 können, bis auf die nachfolgend abweichend beschriebenen Funktionen für die Sende-/Empfangseinrichtungen 12, 32, ansonsten wie ein herkömmlicher CAN-Transceiver und/oder CAN FD-Transceiver und/oder LVCAN-Transceiver ausgeführt sein.

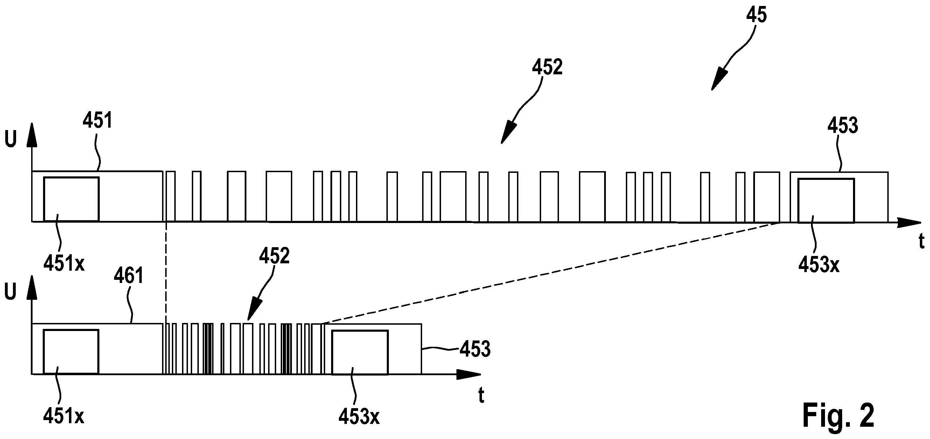

Wie in Fig. 2 anhand der Nachricht 45 für einen CAN-Rahmen oben in Fig. 2 und einen CAN-FD-Rahmen unten in Fig. 2 jeweils als Spannung U über der Zeit t gezeigt, kann die CAN-Kommunikation auf dem Bus 40 grundlegend in zwei unterschiedliche Zeitabschnitte unterteilt werden. Die Nachrichten 46, 47 können auf die gleiche Weise aufgebaut sein.

Die zwei unterschiedlichen Zeitabschnitte der Nachricht 45 umfassen die nur schematisch dargestellten Arbitrierungsphasen 451, 453 und einen Datenbereich 452, der bei CAN-FD auch Datenphase genannt wird und in welchem die Nutzdaten der Nachricht 45 gesendet werden. Bei CAN-FD wird im Vergleich zum klassischen CAN am Ende der Arbitrierungsphase die Datenrate für die folgende Datenphase auf z. B. 2, 4, 8Mbps erhöht. Damit gilt, dass bei CAN-FD die Datenrate in den Arbitrierungsphasen 451, 453 kleiner bzw. schneller als die Datenrate im Datenbereich 452 ist. Bei CAN-FD ist der Datenbereich 452 gegenüber dem Datenbereich 452 des CAN-Rahmens deutlich verkürzt.

In der Arbitrierungsphase 451, 453 wird mit Hilfe einer Identifikationsnummer 451x, 453x bestimmt, welche der derzeit sendenden Teilnehmerstation(en) 10, 20, 30 des Bussystems 1 in dem anschließenden Datenbereich 452 zumindest zeitweise einen exklusiven, kollisionsfreien Zugriff auf den Bus 40 des Bussystems 1 bekommt. In dem Datenbereich 452 findet eine Übertragung der Nutzdaten der Nachricht 45 durch die Teilnehmerstation statt, welche die Arbitrierung gewonnen hat.

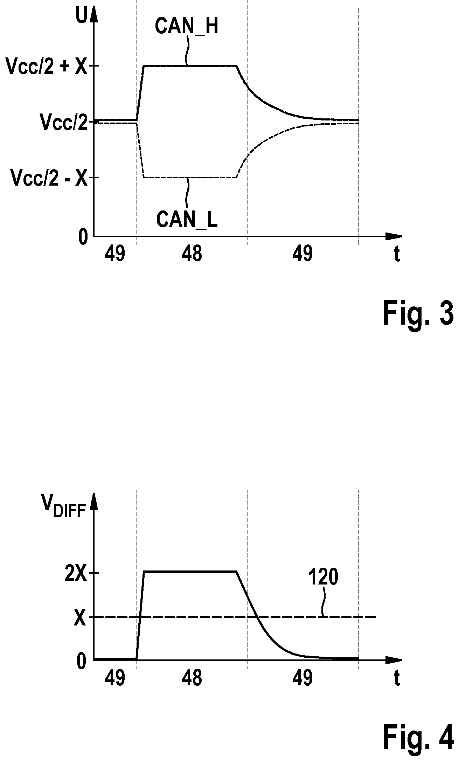

Fig. 3 zeigt als Beispiel Spannungsverläufe von Bussignalen CAN_H, CAN_L über der Zeit t. Die Spannungsverläufe können im Normalbetrieb, also ohne Störungen 50 auf dem Bus 40, in einem Signal einer Nachrichten 45, 46, 47 auftreten. Als Beispiel ist eine Folge von einem rezessiven Buspegel 49, einem dominanten Buspegel 48 und einem rezessiven Buspegel 49 gezeigt. Die Spannungsverläufe der Bussignale CAN_H und CAN_L zeigen bei einem Übergang von einem dominanten Buspegel 48 zu einem rezessiven Buspegel 49 einen deutlich langsameren Zustandswechsel als bei einem Übergang von dem rezessiven Buspegel 49 zu dem dominanten Buspegel 48. Bei CAN FD ist die zeitliche Länge der dominanten Buspegel 48 und rezessiven Buspegel 49 in der Datenphase kürzer als in der Arbitrierungsphase, wie sich auch aus Fig. 2 und deren Beschreibung ergibt.

Gemäß Fig. 3 hat das Bussignal CAN_H normalerweise, also ohne Störungen 50 auf dem Bus 40 und bei einer CAN-Spannungsversorgung von Vcc = 5V, Pegel zwischen 2,5 V und 3,5 V, was Pegeln zwischen Vcc/2 und Vcc/2 +X entspricht. Dagegen hat das Bussignal CAN_L normalerweise, also ohne Störungen 50 auf dem Bus 40 und bei einer CAN-Spannungsversorgung von 5V, Pegel zwischen 1,5 V und 2,5 V, was Pegeln zwischen Vcc/2 - X und Vcc/2 entspricht. Bei LVCAN sind bei einer CAN-Spannungsversorgung von beispielsweise 3,5 V die Pegel für CAN_H und CAN_L entsprechend reduziert.

Wie in Fig. 4 gezeigt, hat demzufolge eine aus den Bussignalen CAN_H, CAN_L resultierende differenzielle Spannung V_{DIFF} = CAN_H - CAN_L somit normalerweise Pegel zwischen 0 V und 2 V, wenn bei einer CAN-Spannungsversorgung von 5V keine Störungen 50 auf dem Bus 40 auftreten. Dies entspricht Pegeln der Spannung V_{DIFF} zwischen 0V und 2X V. Unterschreitet die differenzielle Spannung V_{DIFF} eine Entscheidungsschwelle von 1V bzw. X V, erkennt die Sende-/Empfangseinrichtung 12 einen rezessiven Bussignalpegel. Überschreitet die differenzielle Spannung V_{DIFF} die Entscheidungsschwelle 120 von 1V bzw. X V, erkennt die Sende-/Empfangseinrichtung 12 einen dominanten Bussignalpegel. Bei einer CAN-Spannungsversorgung von beispielsweise 3,5 V für LVCAN ist die Entscheidungsschwelle 120 entsprechend reduziert, insbesondere auf 0,5 V, 0,4 V, 0,2 V, usw.

Treten auf dem Bus 40 Störungen 50 auf, ändern sich die Bussignale CAN_H, CAN_L und somit auch die differenzielle Spannung V_{DIFF} über der Zeit t im Vergleich zu den in Fig. 3 und Fig. 4 gezeigten normalen bzw. erwarteten und dadurch vorbestimmten Signalverläufen. Diese Änderungen werden durch die Störungserkennungseinheit 122 erkannt, wie nachfolgend beschrieben.

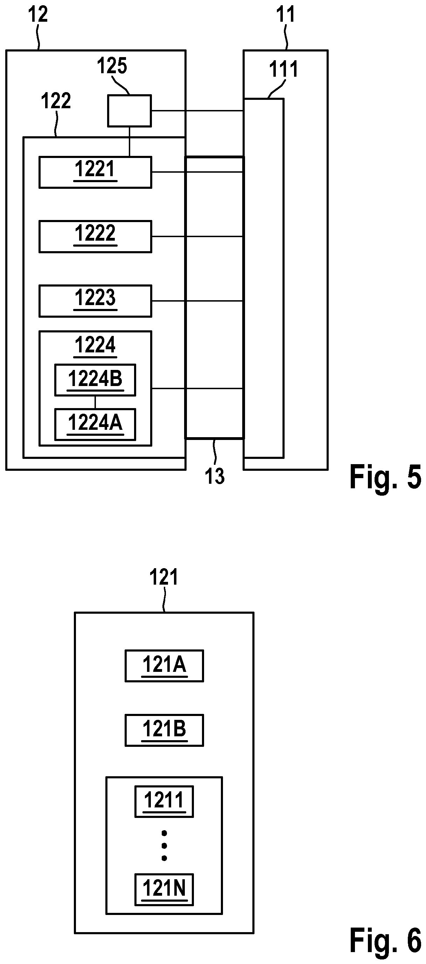

Fig. 5 zeigt die Störungserkennungseinheit 122 genauer, die identisch zu der Störungserkennungseinheit 322 aufgebaut ist. Die Störungserkennungseinheit 122 hat mindestens eines der nachfolgenden Module 1221 bis 1224 zur Überwachung und zum Erkennen von unterschiedlichen Störungen 50, die im Betrieb des Bussystems 1 auftreten können, nämlich ein Einzelpegelüberwachungsmodul 1221 und/oder ein Differenzspannung-Überwachungsmodul 1222 und/oder ein Gleichtaktstörung-Überwachungsmodul 1223 und/oder ein Bandstörung-Überwachungsmodul 1224. Die Störungserkennungseinheit 122 ist über eine Schnittstelle 13 und/oder mindestens einen Anschluss 125 mit der Störungsbehandlungseinheit 111 verbunden.

Das Einzelpegelüberwachungsmodul 1221 überwacht die Einzelpegel der Bussignale CAN_H, CAN_L. Hierbei wird überwacht, ob sich einer der Pegel besonders schnell ändert, insbesondere die Flankensteilheit an einem Übergang zwischen den Zuständen 49, 48 größer als normal ist, wie in Fig. 3 gezeigt. Zusätzlich oder alternativ kann überwacht werden, ob einer der Pegel über längere Zeit ungewöhnlich stark vom gewohnten bzw. vorbestimmten Bereich abweicht, nämlich für CAN_H von dem vorbestimmten Bereich von 2,5V bis 3,5V und für CAN_L von dem vorbestimmten Bereich von 1,5V bis 2,5V. Zusätzlich oder alternativ wird überwacht, ob einer der Pegel so hoch ist, dass eine Begrenzung durch interne Schutzdioden z.B. -+-58V wegen elektrostatischer Entladung oder ein hoher Gleichtakt verursacht durch EMV-Einkopplung nicht ausgeschlossen werden kann.

Das Differenzspannung-Überwachungsmodul 1222 überwacht, ob eine differenzielle Störung 50 vorliegt oder nicht. Hierbei wird überwacht, ob das Signal der differenziellen Spannung V_{DIFF} außerhalb des erwarteten bzw. vorbestimmten Bereichs von 0 V bis 2 V liegt, wie in Fig. 4 gezeigt. Zusätzlich oder alternativ wird überwacht, ob sich das Signal der differenziellen Spannung V_{DIFF} ungewöhnlich schnell oder ungewöhnlich langsam ändert. Ungewöhnlich schnell bedeutet insbesondere, dass der Übergang zwischen den einzelnen Buszuständen 48, 49 oder 49, 48 schneller stattfindet als bei einer normal langen und damit vorbestimmten Bitdauer, wie in Fig. 4 gezeigt. Ungewöhnlich langsam bedeutet insbesondere, dass bedeutet, dass der Übergang zwischen den einzelnen Buszuständen 48, 49 oder 49, 48 langsamer stattfindet als bei einer normal langen und damit vorbestimmten Bitdauer, wie in Fig. 4 gezeigt. Zusätzlich oder alternativ wird überwacht, ob sich das Signal der differenziellen Spannung V_{DIFF} über längere Zeit ungewöhnlich nahe an der Entscheidungsschwelle 120 von 1V bewegt, wie in Fig. 4 gezeigt. Es wird also insbesondere überwacht, ob das Signal der differenziellen Spannung V_{DIFF} länger als eine vorbestimmte Zeit in etwa gleich der Entscheidungsschwelle 120 von 1V ist.

Das Gleichtaktstörung-Überwachungsmodul 1223 überwacht, ob die durchschnittliche Spannung aus beiden Signalen CAN_H, CAN_L besonders schnell oder über längere Zeit besonders stark vom erwarteten Wert von 2,5 Volt, dem Gleichtaktsignal, abweicht. Besonders schnell oder über längere Zeit bedeutet insbesondere, dass die Flankensteilheit der Signale CAN_H, CAN_L bei Übergängen zwischen den Buszuständen 49, 48 steiler ist als der in Fig. 3 im normalen Verlauf gezeigte, vorbestimmte Wert oder bei Übergängen zwischen den Buszuständen 48, 49 flacher ist als der in Fig. 3 im normalen Verlauf gezeigte, vorbestimmte Wert.

Das Bandstörung-Überwachungsmodul 1224 überwacht mindestens einen vorbestimmten Frequenzbereich von mindestens einem der oben genannten Signale, nämlich Einzelsignal (CAN_H, CAN_L), Differenzsignal (_{VDIFF}) und Gleichtaktsignal. Hierfür wird der mindestens eine vorbestimmte Frequenzbereich mittels Filter 1224A herausgegriffen und das dem mindestens einen vorbestimmten Frequenzbereich entsprechende Ausgangssignal des Filters 1224A auf mindestens einen Analog-Digital-Wandler 1224B gegeben. Das Filter 1224A ist als mindestens ein Bandpass und/oder als mindestens eine HF-Gleichrichterschaltung ausführbar.

Die Störungserkennungseinheit 122 der Sende-/Empfangseinrichtung 12, genauer ihre Module 1221 bis 1224 messen die jeweils vorhandenen Störungen 50 auf dem Bus 49 und teilen der Kommunikationssteuereinrichtung 11 mit, welcher Art und wie groß die Störungen 50 sind. Genauer gesagt, erfolgt die Mitteilung von der Störungserkennungseinheit 122 an die Störungsbehandlungseinheit 111. Die Störungsbehandlungseinheit 111 ist identisch wie die Störungsbehandlungseinheit 311 aufgebaut.

Die Mitteilung von der Sende-/Empfangseinrichtung 12 an die Kommunikationssteuereinrichtung 11 bzw. von der Einheit 122 an die Einheit 111 kann entweder durch die gegebenenfalls bereits vorhandene Datenschnittstelle 13 wie z.B. SPI, I²C, usw., geschehen und/oder mit zusätzlichen speziellen Anschlüssen 125 an der Sende-/Empfangseinrichtung 12, wie z.B. digital-Signal, PWM, SENT, Analog, usw. ausgeführt werden, wie in Fig. 5 als ein spezielles Beispiel veranschaulicht.

Die Kommunikationssteuereinrichtung 11, insbesondere ihre Störungsbehandlungseinheit 111, kann als Reaktion auf die Mitteilung von der Sende-/Empfangseinrichtung 12, welche Störungen 50 derzeit auf dem Bus 40 und in welcher Höhe vorhanden sind, angemessen auf ihre Kommunikation einwirken. Hierfür kann die Kommunikationssteuereinrichtung 11 mindestens eine der nachfolgenden Maßnahmen ergreifen, um ihre Kommunikation zu steuern, nämlich:
- die mindestens eine erkannte Störung 50 den anderen Teilnehmerstationen 20, 30 im Bussystem 1 mitteilen, und/oder
- auf das Versenden niederpriorer Nachrichten verzichten, und/oder
- sicherheitsrelevante Nachrichten redundant über einen weiteren Kommunikationskanal oder zeitlich versetzt senden, und/oder
- abhängig von der mindestens einen erkannten Störung 50, die Bit-Timing-Parameter anpassen, wie beispielsweise Bitratenvorteiler (bit rate prescaler), Abtastpunkt (sample point), Synchronisationssprungweite (synchronization jump width), usw., und/oder
- bei CAN-FD: Die Datenrate nach der Arbitrierung nicht erhöhen, obwohl der Fehlerzähler 121 noch nicht die normalerweise dazu erforderliche Schwelle erreicht hat, und/oder
- bei LVCAN: Die Höhe der Spannungsversorgung und damit die maximale Amplitude der Differenzspannung V_{DIFF} nicht reduzieren und die Datenrate nicht erhöhen, obwohl der Fehlerzähler 121 noch nicht die normalerweise dazu erforderliche Schwelle erreicht hat.

Die Kommunikationssteuereinrichtung 11, genauer ihre Störungsbehandlungseinheit 111, kann mit der Mitteilung von der Sende-/Empfangseinrichtung 12 äußere Störungen 50 von inneren Störungen 50 unterscheiden, da äußere Störungen 50 sowohl beim Senden und Empfangen der Signale, die inneren Störungen 50 aber hauptsächlich beim Senden der Signale auftreten. Die Unterscheidung zwischen äußeren und inneren Störungen 50 ist für Servicepersonal wichtig, dass bei einer Suche zur Behebung der Störung 50 des Bussystems 1 aufgrund dieser Unterscheidung den Verursacher der Störung 50 schneller eingrenzen und den für die Störung 50 verantwortlichen Fehler schneller beheben kann.

Mit den Teilnehmerstationen 10, 30 können somit Störungen 50 frühzeitiger erkannt werden. Als Folge davon ist das Bussystem 1 robuster gegenüber kurzzeitigen Störungen 50, insbesondere EMV-Störungen, weil sich die Kommunikation besser an geänderte Umgebungsbedingungen anpassen kann, wie zuvor beschrieben. Dadurch sind ein optimaler Betrieb und bei Mitteilung von Störungen 50 zwischen den Teilnehmerstationen 10, 30 eine leichtere und kostengünstigere Reparatur des Bussystems 1 möglich.

Gemäß einer Modifikation des zuvor beschriebenen Ausführungsbeispiels ist es möglich, dass mindestens einer Teilnehmerstation der Teilnehmerstationen 10, 20, 30 bekannt ist, welche Nachrichten 45, 46, 47 von welcher Teilnehmerstation 10, 20, 30 gesendet werden. In diesem Fall kann diese mindestens eine Teilnehmerstation 10, 20, 30 während des Empfangs der Nachrichten 45, 46, 47 die Störung(en) 50, die durch das Senden entstehen, für jede einzelne Teilnehmerstation 10, 20, 30 separat aufsummieren, beispielsweise mittels einer Vielzahl von Zählwerken des Fehlerzählers 121, und für ein späteres Auslesen durch Servicepersonal abspeichern. Dadurch wird die Fehlersuche zusätzlich erleichtert. Das Abspeichern kann beispielsweise mit Hilfe einer Speicherfunktion der Störungsbehandlungseinrichtung 111 erfolgen.

Fig. 6 zeigt für eine Erläuterung eines zweiten Ausführungsbeispiels den Fehlerzähler 121 genauer. Bei dem zweiten Ausführungsbeispiel werden die Zählweisen für die Empfangsfehlerzähler 121A und Sendefehlerzähler 121B des Feherzählers 121 angepasst, wie folgt.

Zur Erkennung und zur Behandlung von Störungen 50, die einen Empfangsfehler verursachen, wird der Empfangsfehlerzähler 121A nach wie vor bei jedem erkannten Empfangsfehler um 1 erhöht. Wenn allerdings der Empfangsfehler bzw. die Störung 50 unter allen Teilnehmerstationen 10, 20, 30 von der Teilnehmerstation 10 als Erste erkannt wurde, wird der Empfangsfehlerzähler 121A nur bei der Teilnehmerstation 10 dann um weitere 8 erhöht, wenn die erkannte Störung(en) 50 während des Empfangs klein waren. Je größer die Störung(en) 50 während des Empfangs, umso geringer ist die zusätzliche Erhöhung des Empfangsfehlerzählers 121A.

Außerdem wird der Sendefehlerzähler 121B bei jedem erkannten Sendefehler mindestens um 1 erhöht. Zusätzlich wird der Sendefehlerzähler 121B um weitere Punkte erhöht, je kleiner die Störung(en) 50 vor bzw. nach dem Versand der Nachricht (End-of-Frame bzw. Interframespace, Error-Delemiter) und je größer die Störung(en) 50 während des Sendens sind, umso mehr weitere Punkte.

Ganz allgemein werden der Empfangsfehlerzähler 121A und der Sendefehlerzähler 121B abhängig von der Art der Störung und/oder des zeitlichen Auftritts bei Versenden einer der Nachrichten 45, 46, 47 über den Bus 40 inkrementiert oder dekrementiert.

Generell soll anhand der Fehlerzähler 121A, 121B bzw. entsprechenden Fehlerzählern der Teilnehmerstation 30 erkannt werden, wie gut bzw. schlecht die Teilnehmerstation 10, 30 unter guten EMV-Bedingungen empfangen kann. Sind die EMV-Bedingungen dagegen schlecht, ist zu erwarten, dass die Teilnehmerstation 10, 30 viele Nachrichten 45, 46, 47 fehlerhaft empfängt, ohne dass das auf einen Defekt in der Sende-/Empfangseinrichtung 12, 32 hinweisen muss. Darum wird der Fehlerzähler 121 und/oder die Fehlerzähler 121A, 121B bzw. die entsprechenden Fehlerzähler der Teilnehmerstation 30 während schlechter EMV-Bedingungen nicht so schnell hochgezählt wie bei guten EMV-Bedingungen.

Zusätzlich oder alternativ können die Schwellen 1211 bis 121N für Fehlerzustände angepasst werden. So können die Schwellen 1211 bis 121N für den Übergang zum Fehlerpassivzustand und/oder zum Bus-Off-Zustand angehoben werden, wenn zwischen dem Versand der Nachrichten 45 (End-of-Frame bzw. Interframespace, Error-Delemiter) über längere Zeit Störung(en) 50 erkannt worden sind.

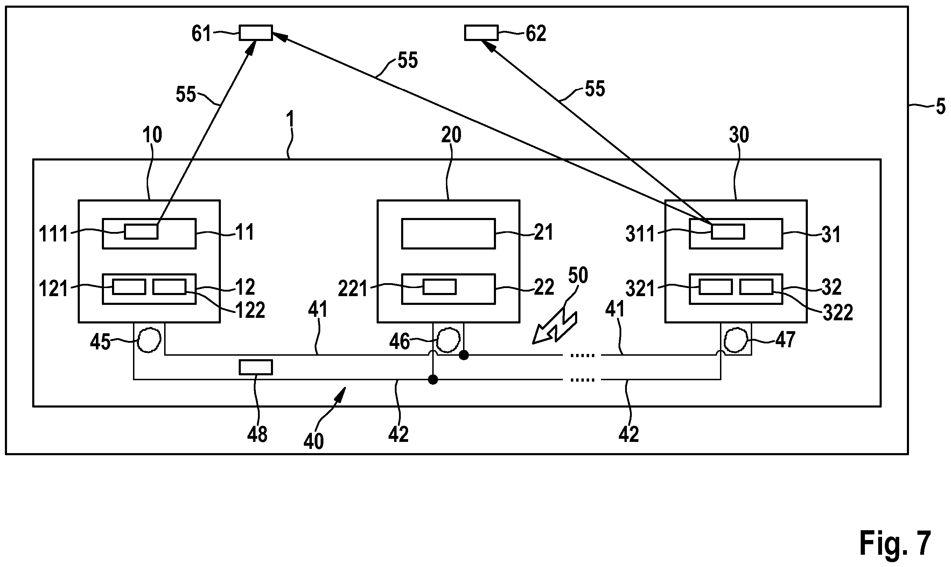

Fig. 7 zeigt ein System 5 gemäß einem dritten Ausführungsbeispiel. In dem System 5 wird mit den Störungsbehebungsmodulen 111, 311 eine Nachricht 55 als Vorwarnung für andere Sensoren 61, 62 erstellt und gesendet. Hierbei wird berücksichtigt, dass die Bedingungen in Bezug auf die elektromagnetische Verträglichkeit (EMV) meist nicht nur auf das Bussystem 1, sondern auch auf Sensorik einwirken. Zusätzlich oder alternativ zu der Vorwarnung mit der Nachricht 55 ist eine Herabsetzung des Vertrauensindex in bestimmte Sensordaten möglich, die im Umfeld der Störung 50 auf dem Bus 40 vorhanden sind und daher durch die Busstörung 50 beeinträchtigt, insbesondere verfälscht oder zerstört werden können.

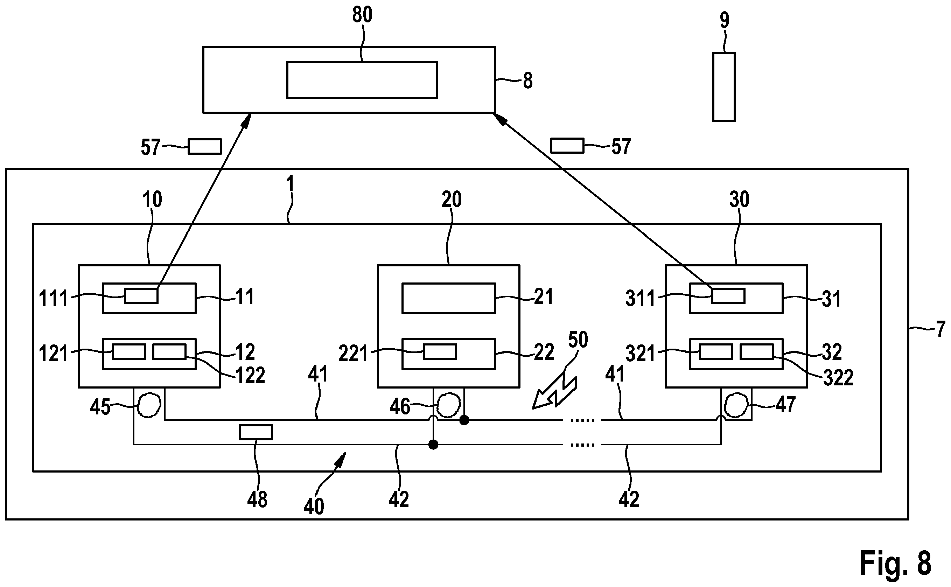

Fig. 8 zeigt ein System 7 mit einer Zentrale 8 gemäß einem vierten Ausführungsbeispiel. Hier sendet mindestens ein System 7, das insbesondere ein Fahrzeug, ein Werkzeug, usw. mit GPS-Empfang sein kann, die EMV-Einstrahlung von Strahlungsquellen 9, wie beispielsweise Hochspannungsmasten, Zündanlagen von Neonlampen, etc. an die Zentrale 8, die insbesondere eine Cloud, eine Verkehrsleitzentrale, usw. ist. An der Zentrale 8 kann dann eine geographische Karte 80 mit EMV-Belastung erstellt werden.

Dies ermöglicht noch frühzeitigere Eingriffe durch das Bussystem 1. So ist es denkbar, dass Insasse(n) von autonomen Fahrzeugen als das System 7 vor Stellen mit erhöhter EMV-Einstrahlung, wie den Strahlungsquellen 9, rechtzeitig aufgefordert werden, selbst die Kontrolle des Fahrzeugs zu übernehmen.

Alle zuvor beschriebenen Ausgestaltungen des Bussystems 1, der Systeme 5, 7 der Teilnehmerstationen 10, 20, 30 und des Verfahrens können einzeln oder in allen möglichen Kombinationen Verwendung finden. Insbesondere können alle Merkmale der zuvor beschriebenen Ausführungsbeispiele und/oder deren Modifikationen beliebig kombiniert oder weggelassen werden. Zusätzlich sind insbesondere folgende Modifikationen denkbar.

Das zuvor beschriebene Bussystem 1 gemäß den Ausführungsbeispielen ist anhand eines auf dem CAN-Protokoll oder CAN FD-Protokoll basierenden Bussystems beschrieben. Das Bussystem 1 gemäß den unterschiedlichen Ausführungsbeispielen kann jedoch auch eine andere Art von Kommunikationsnetz sein. Es ist vorteilhaft, jedoch nicht zwangsläufige Voraussetzung, dass bei dem Bussystem 1 zumindest für bestimmte Zeitspannen ein exklusiver, kollisionsfreier Zugriff einer Teilnehmerstation 10, 20, 30 auf den Bus 40 gewährleistet ist.

Das Bussystem 1 gemäß den Ausführungsbeispielen ist insbesondere ein CAN-Netzwerk oder ein CAN FD-Netzwerk oder ein FlexRay-Netzwerk oder ein SPI-Netzwerk.

Es ist denkbar, dass eine der zwei Busadern 41, 42 mit Masse verbunden ist und somit eine Masseader ist und die andere der zwei Busadern 41, 42 eine Signalader ist, auf welcher das Bussignal für die Nachrichten 45, 46, 47 übertragen wird.

Die Anzahl und Anordnung der Teilnehmerstationen 10, 20, 30 in dem Bussystem 1 gemäß den Ausführungsbeispielen ist beliebig. Insbesondere können nur Teilnehmerstationen 10 oder Teilnehmerstationen 30 in den Bussystemen 1 der Ausführungsbeispiele vorhanden sein.

Die Funktionalität der zuvor beschriebenen Ausführungsbeispiele lässt sich nicht nur umsetzen, wie zuvor beschrieben. Zusätzlich oder alternativ kann die Funktionalität in existierende Produkte integriert werden, wie in eine der Kommunikationssteuereinrichtungen 11, 31 oder in eine der Sende-/Empfangseinrichtungen 12, 32. Insbesondere ist es möglich, dass die betrachtete Funktionalität als separater elektronischer Baustein (Chip) realisiert wird oder in einer integrierten Gesamtlösung eingebettet ist, bei welchem nur ein elektronischer Baustein (Chip) für Kommunikationssteuereinrichtung 11, Sende-/Empfangseinrichtung 12 und die Funktion der Einheiten 111, 122 und/oder der Zähler 121 vorhanden ist.

## Patentansprüche

1. Teilnehmerstation (10; 30) für ein serielles Bussystem (1), mit
einer Kommunikationssteuereinrichtung (11; 31) zur Steuerung einer Kommunikation mit mindestens einer weiteren Teilnehmerstation (10, 20, 30) des Bussystems (1),
einer Sende-/Empfangseinrichtung (12; 32) zum Empfangen einer Nachricht (45; 46; 47) von einem Bus (40) des Bussystems (1), die von der Kommunikationssteuereinrichtung (11; 31) oder der mindestens eine weitere Teilnehmerstation (20; 30; 10) des Bussystems (1) erstellt wurde und auf dem Bus (40) übertragen wird,
einer Störungserkennungseinheit (122; 322), die ausgestaltet ist zur Erkennung einer Störung (50) beim Übertragen der Nachricht (45; 46; 47) auf dem Bus (40), und
einer Störungsbehandlungseinheit (111; 311), die ausgestaltet ist zur Auswertung der von der Störungserkennungseinheit (122; 322) erkannten Störung (50) in Bezug auf Art und Größe der Störung (50) und zur Anpassung der Steuerung der Kommunikation der Kommunikationssteuereinrichtung (11; 31) an das Ergebnis der Auswertung der Störung (50), **dadurch gekennzeichnet, dass** die Störungserkennungseinheit (122; 322) ein Gleichtaktstörung-Überwachungsmodul (1223) zur Überwachung, ob die durchschnittliche Spannung aus den differenziellen Bussignalen (CAN_H, CAN_L) schneller als vorbestimmt oder für eine vorbestimmte Zeit von einem vorbestimmten Wert abweicht, aufweist.

2. Teilnehmerstation (10; 30) nach Anspruch 1, wobei die Störungsbehandlungseinheit (111; 311) ausgestaltet ist, zwischen äußerer und innerer Störung (50) der Übertragung der Nachricht (45; 46; 47) auf dem Bus (40) zu unterscheiden.

3. Teilnehmerstation (10; 30) nach Anspruch 1 oder 2, wobei die Störungserkennungseinheit (122; 322) aufweist
ein Einzelpegelüberwachungsmodul (1221) zur Überwachung von Einzelpegeln von differenziellen Bussignalen (CAN_H, CAN_L), und/oder
ein Differenzspannung-Überwachungsmodul (1222) zur Überwachung, ob eine differenzielle Spannung (V_{DIFF}) außerhalb eines vorbestimmten Bereichs liegt, und/oder
ein Bandstörung-Überwachungsmodul (1224) zur Überwachung von vorbestimmten Frequenzbereichen der oben genannten Signale.

4. Teilnehmerstation (10; 30) nach Anspruch 3,
wobei das Einzelpegelüberwachungsmodul (1221) ausgestaltet ist zu überwachen, ob sich einer der Pegel besonders schnell ändert und/oder über eine vorbestimmte Zeit von einem vorbestimmten Bereich abweicht, und/oder
wobei das Einzelpegelüberwachungsmodul (1221) ausgestaltet ist zu überwachen, ob einer der Pegel so hoch ist, dass eine Begrenzung durch interne Schutzdioden wegen elektrostatischer Entladung oder ein hoher Gleichtakt verursacht durch EMV-Einkopplung nicht ausgeschlossen werden kann.

5. Teilnehmerstation (10; 30) nach Anspruch 3,
wobei das Differenzspannung-Überwachungsmodul (1222) ausgestaltet ist zu überwachen, ob sich das Signal der differenziellen Spannung (V_{DIFF}) ungewöhnlich schnell oder ungewöhnlich langsam ändert, und/oder
wobei das Differenzspannung-Überwachungsmodul (1222) ausgestaltet ist zu überwachen, ob sich das Signal der differenziellen Spannung (V_{DIFF}) über längere Zeit ungewöhnlich nahe an einer in der Sende-/Empfangseinrichtung (12; 32) eingestellten Entscheidungsschwelle (120) bewegt, mit welcher die Sende-/Empfangseinrichtung (12; 32) ausgestaltet ist zu entscheiden, ob das Signal der differenziellen Spannung (V_{DIFF}) einem rezessiven Buszustand oder einem dominanten Buszustand entspricht.

6. Teilnehmerstation (10; 30) nach Anspruch 3,
wobei das Bandstörung-Überwachungsmodul (1224) ein Filter (1224A) aufweist, um die bestimmten Frequenzbereiche herauszugreifen, und
wobei das Filter (1124A) mindestens ein Bandpass und/oder mindestens eine Hochfrequenz-Gleichrichterschaltung ist und das Filter (1124A) an seinem Ausgang mit mindestens einem Analog-Digital-Wandler (1224B) verbunden ist.

7. Teilnehmerstation (10; 30) nach einem der vorangehenden Ansprüche,
wobei die Störungsbehandlungseinheit (111; 311) ausgestaltet ist, die Steuerung der Kommunikation der Kommunikationssteuereinrichtung (11; 31) durch mindestens eine der nachfolgenden Maßnahmen anzupassen
Mitteilen der Störung (50) mit einer Nachricht (45; 46; 47) an mindestens eine der anderen Teilnehmerstationen (20, 30) im Bussystem (1), und/oder
Verzicht auf das Versenden niederpriorer Nachrichten (46), und/oder
Senden von sicherheitsrelevanten Nachrichten (47) redundant über einen weiteren Kommunikationskanal oder zeitlich versetzt, und/oder
Anpassen mindestens eines Bit-Timing-Parameters für die Nachricht (45; 46; 47) abhängig von der erkannten Störung (50), und/oder
nicht Erhöhen der Datenrate nach der Arbitrierungsphase (451, 453) für eine CAN-FD-Nachricht (45; 46; 47), obwohl ein Fehlerzähler (121; 321) noch nicht die normalerweise dazu erforderliche Schwelle (1211 bis 121N) erreicht hat, und/oder
nicht Reduzieren der maximalen Amplitude der Differenzspannung (V_{DIFF}) für eine LVCAN-Nachricht und damit nicht Erhöhen der Datenrate, obwohl ein Fehlerzähler (121; 321) noch nicht die dazu erforderliche vorbestimmte Schwelle erreicht hat.

8. Teilnehmerstation (10; 30) nach einem der vorangehenden Ansprüche, wobei die Störungsbehandlungseinheit (111; 311) ausgestaltet ist, die Störung (50) mit einer Nachricht (55) mindestens einem Sensor (61, 62) mitzuteilen, der mit der Teilnehmerstation (10; 30) verbunden ist.

9. Teilnehmerstation (10; 30) nach einem der vorangehenden Ansprüche, zudem mit einem Fehlerzähler (121; 321), der ausgestaltet ist, für jede Teilnehmerstation (10, 20, 30) des Bussystems (1) die mindestens eine Störung (50) separat aufzusummieren, die durch das Senden der Nachricht (45; 46; 47) mit der Sende-/Empfangseinrichtung (12; 32) entsteht.

10. Teilnehmerstation (10; 30) nach einem der vorangehenden Ansprüche, zudem mit einem Empfangsfehlerzähler (121A) und einem Sendefehlerzähler (121B), die abhängig von der Art der Störung und/oder des zeitlichen Auftritts bei Versenden der Nachricht (45; 46; 47) über den Bus (40) inkrementiert oder dekrementiert werden.

11. Bussystem (1), mit
einem Bus (40), und
mindestens zwei Teilnehmerstationen (10, 30) nach einem der vorangehenden Ansprüche, welche über den Bus (40) derart miteinander verbunden sind, dass sie miteinander kommunizieren können.

12. Bussystem (1) nach Anspruch 11, wobei die mindestens zwei Teilnehmerstationen (10, 30) ausgestaltet sind, Daten (57) über die Störung (50) an eine Zentrale (8) zur Verwendung in einer Karte (80) zu senden, welche die der Störung (50) entsprechende EMV-Belastung geographisch darstellt.

13. Verfahren zur Datenübertragung in einem seriellen Bussystem (1), in welchem mindestens zwei Teilnehmerstation (10; 30) über einen Bus (40) derart miteinander verbunden sind, dass sie miteinander kommunizieren können, wobei das Verfahren die Schritte aufweist
seriell Empfangen, mit einer Sende-/Empfangseinrichtung (12; 32) einer der Teilnehmerstationen (10; 30), einer Nachricht (45; 46; 47) von dem Bus (40), die von einer Kommunikationssteuereinrichtung (11; 31) der Teilnehmerstation (10; 30) oder der mindestens einen weiteren Teilnehmerstation (20; 30; 10) des Bussystems (1) erstellt wurde und auf dem Bus (40) übertragen wird,
Erkennen, mit einer Störungserkennungseinheit (122; 322), einer Störung (50) beim Übertragen der Nachricht (45; 46; 47) auf dem Bus (40),
Auswerten, mit einer Störungsbehandlungseinheit (111; 311), der von der Störungserkennungseinheit (122; 322) erkannten Störung (50) in Bezug auf Art und Größe der Störung (50), und
Anpassen einer Steuerung der Kommunikation der Kommunikationssteuereinrichtung (11; 31) an das Ergebnis der Auswertung der Störung (50), **dadurch gekennzeichnet, dass** die Störungserkennungseinheit (122; 322) ein Gleichtaktstörung-Überwachungsmodul (1223) zur Überwachung, ob die durchschnittliche Spannung aus den differenziellen Bussignalen (CAN_H, CAN_L) schneller als vorbestimmt oder für eine vorbestimmte Zeit von einem vorbestimmten Wert abweicht, aufweist.

## Claims

1. Subscriber station (10; 30) for a serial bus system (1), having
a communication control device (11; 31) for controlling communication with at least one further subscriber station (10, 20, 30) of the bus system (1),
a transmitting/receiving device (12; 32) for receiving a message (45; 46; 47) from a bus (40) of the bus system (1), which message was created by the communication control device (11; 31) or the at least one further subscriber station (20; 30; 10) of the bus system (1) and is transmitted on the bus (40),
an interference detection unit (122; 322) which is configured to detect interference (50) during transmission of the message (45; 46; 47) on the bus (40), and
an interference management unit (111; 311) which is configured to evaluate the interference (50) detected by the interference detection unit (122; 322) with respect to the type and magnitude of the interference (50) and to adapt the control of the communication of the communication control device (11; 31) to the result of the evaluation of the interference (50), **characterized in that** the interference detection unit (122; 322) has a common-mode interference monitoring module (1223) for monitoring whether the average voltage from the differential bus signals (CAN_H, CAN_L) differs from a predetermined value more quickly than predetermined or for a predetermined time.

2. Subscriber station (10; 30) according to Claim 1, wherein the interference management unit (111; 311) is configured to distinguish between external and internal interference (50) in the transmission of the message (45; 46; 47) on the bus (40).

3. Subscriber station (10; 30) according to Claim 1 or 2, wherein the interference detection unit (122; 322) has
an individual level monitoring module (1221) for monitoring individual levels of differential bus signals (CAN_H, CAN_L), and/or
a differential voltage monitoring module (1222) for monitoring whether a differential voltage (V_{DIFF}) is outside a predetermined range, and/or
a band interference monitoring module (1224) for monitoring predetermined frequency ranges of the above-mentioned signals.

4. Subscriber station (10; 30) according to Claim 3,
wherein the individual level monitoring module (1221) is configured to monitor whether one of the levels changes particularly quickly and/or differs from a predetermined range over a predetermined time, and/or
wherein the individual level monitoring module (1221) is configured to monitor whether one of the levels is so high that limitation by means of internal protective diodes cannot be ruled out on account of electrostatic discharge or high common mode caused by EMC coupling.

5. Subscriber station (10; 30) according to Claim 3,
wherein the differential voltage monitoring module (1222) is configured to monitor whether the signal of the differential voltage (V_{DIFF}) changes unusually quickly or unusually slowly, and/or
wherein the differential voltage monitoring module (1222) is configured to monitor whether the signal of the differential voltage (V_{DIFF}) moves, over a relatively long time, unusually close to a decision threshold (120) which is set in the transmitting/receiving device (12; 32) and with which the transmitting/receiving device (12; 32) is configured to decide whether the signal of the differential voltage (V_{DIFF}) corresponds to a recessive bus state or to a dominant bus state.

6. Subscriber station (10; 30) according to Claim 3,
wherein the band interference monitoring module (1224) has a filter (1224A) in order to pick out the particular frequency ranges, and
wherein the filter (1124A) is at least one bandpass filter and/or at least one high-frequency rectifier circuit, and the output of the filter (1124A) is connected to at least one analogue/digital converter (1224B).

7. Subscriber station (10; 30) according to one of the preceding claims,
wherein the interference management unit (111; 311) is configured to adapt the control of the communication of the communication control device (11; 31) by means of at least one of the following measures
communicating the interference (50) with a message (45; 46; 47) to at least one of the other subscriber stations (20, 30) in the bus system (1), and/or
dispensing with the transmission of low-priority messages (46), and/or
transmitting safety-relevant messages (47) in a redundant manner via a further communication channel or with a time delay, and/or
adapting at least one bit timing parameter for the message (45; 46; 47) on the basis of the detected interference (50), and/or
failing to increase the data rate after the arbitration phase (451, 453) for a CAN-FD message (45; 46; 47) even though an error counter (121; 321) has not yet reached the threshold (1211 to 121N) normally required for this, and/or
failing to reduce the maximum amplitude of the differential voltage (V_{DIFF}) for an LVCAN message and therefore failing to increase the data rate even though an error counter (121; 321) has not yet reached the predetermined threshold required for this.

8. Subscriber station (10; 30) according to one of the preceding claims, wherein the interference management unit (111; 311) is configured to communicate the interference (50) with a message (55) to at least one sensor (61, 62) connected to the subscriber station (10; 30) .

9. Subscriber station (10; 30) according to one of the preceding claims, also having an error counter (121; 321) which is configured to separately sum, for each subscriber station (10, 20, 30) of the bus system (1), the at least one interference (50) caused by transmitting the message (45; 46, 47) using the transmitting/receiving device (12; 32).

10. Subscriber station (10; 30) according to one of the preceding claims, also having a receiving error counter (121A) and a transmitting error counter (121B) which are incremented or decremented depending on the type of interference and/or the time at which it occurs when transmitting the message (45; 46; 47) via the bus (40).

11. Bus system (1) having
a bus (40), and
at least two subscriber stations (10, 30) according to one of the preceding claims which are connected to one another via the bus (40) in such a manner that they can communicate with one another.

12. Bus system (1) according to Claim 11, wherein the at least two subscriber stations (10, 30) are configured to transmit data (57) relating to the interference (50) to a control centre (8) for use in a map (80) which geographically represents the EMC load corresponding to the interference (50).

13. Method for transmitting data in a serial bus system (1), in which at least two subscriber stations (10; 30) are connected to one another via a bus (40) in such a manner that they can communicate with one another, wherein the method has the steps of
using a transmitting/receiving device (12; 32) of one of the subscriber stations (10; 30) to serially receive a message (45; 46; 47) from the bus (40), which message was created by a communication control device (11; 31) of the subscriber station (10; 30) or of the at least one further subscriber station (20; 30; 10) of the bus system (1) and is transmitted on the bus (40),
using an interference detection unit (122; 322) to detect interference (50) when transmitting the message (45; 46; 47) on the bus (40),
using an interference management unit (111; 311) to evaluate the interference (50) detected by the interference detection unit (122; 322) with respect to the type and magnitude of the interference (50), and
adapting control of the communication of the communication control device (11; 31) to the result of the evaluation of the interference (50), **characterized in that** the interference detection unit (122; 322) has a common-mode interference monitoring module (1223) for monitoring whether the average voltage from the differential bus signals (CAN_H, CAN_L) differs from a predetermined value more quickly than predetermined or for a predetermined time.

## Revendications

1. Station d'abonné (10 ; 30) pour un système de bus série (1), comprenant
un dispositif de commande de communication (11 ; 31) permettant de commander une communication avec au moins une autre station d'abonné (10, 20, 30) du système de bus (1),
un dispositif d'émission/réception (12 ; 32) permettant de recevoir un message (45 ; 46 ; 47) de la part d'un bus (40) du système de bus (1) et qui a été créé par le dispositif de commande de communication (11 ; 31) ou ladite au moins une autre station d'abonné (20 ; 30 ; 10) du système de bus (1) et est transmis sur le bus (40),
une unité d'identification de perturbation (122 ; 322) qui est configurée pour identifier une perturbation (50) lors de la transmission du message (45 ; 46 ; 47) sur le bus (40), et
une unité de gestion de perturbation (111 ; 311) qui est configurée pour évaluer la perturbation (50) identifiée par l'unité d'identification de perturbation (122 ; 322) en termes de type et de degré de la perturbation (50) et pour adapter la commande de la communication du dispositif de commande de communication (11 ; 31) au résultat de l'évaluation de la perturbation (50),
**caractérisée en ce que** l'unité d'identification de perturbation (122 ; 322) présente un module de surveillance de perturbation de mode commun (1223) permettant de surveiller si la tension moyenne provenant des signaux de bus différentiels (CAN_H, CAN_L) dévie d'une valeur prédéterminée plus rapidement que prédéterminé ou pendant une durée prédéterminée.

2. Station d'abonné (10 ; 30) selon la revendication 1, dans laquelle l'unité de gestion de perturbation (111; 311) est configurée pour faire la différence entre une tension extérieure et une tension intérieure (50) de la transmission du message (45 ; 46 ; 47) sur le bus (40).

3. Station d'abonné (10 ; 30) selon la revendication 1 ou 2, dans laquelle l'unité d'identification de perturbation (122 ; 322) présente
un module de surveillance de niveau unique (1221) permettant de surveiller des niveaux uniques de signaux de bus différentiels (CAN_H, CAN_L), et/ou
un module de surveillance de tension différentielle (1222) permettant de surveiller si une tension différentielle (V_{DIFF}) est en dehors d'une plage prédéterminée, et/ou
un module de surveillance de perturbation de bande (1224) permettant de surveiller des plages de fréquence prédéterminées desdits signaux.

4. Station d'abonné (10 ; 30) selon la revendication 3,
le module de surveillance de niveau unique (1221) étant configuré pour surveiller si l'un des niveaux change de manière particulièrement rapide et/ou dévie d'une plage prédéterminée pendant une durée prédéterminée, et/ou
le module de surveillance de niveau unique (1221) étant configuré pour surveiller si l'un des niveaux est si élevé qu'il est impossible d'exclure une limitation par des diodes de protection internes en raison d'une décharge électrostatique ou un mode commun élevé provoqué par un couplage CEM.

5. Station d'abonné (10 ; 30) selon la revendication 3,
le module de surveillance de tension différentielle (1222) étant configuré pour surveiller si le signal de la tension différentielle (V_{DIFF}) change de manière anormalement rapide ou anormalement lente, et/ou
le module de surveillance de tension différentielle (1222) étant configuré pour surveiller si le signal de la tension différentielle (V_{DIFF}) se trouve pendant une certaine durée anormalement près d'un seuil de décision (120) réglé dans le dispositif d'émission/réception (12 ; 32) à l'aide duquel le dispositif d'émission/réception (12 ; 32) est configuré pour décider si le signal de la tension différentielle (V_{DIFF}) correspond à un état de bus récessif ou à un état de bus dominant.

6. Station d'abonné (10 ; 30) selon la revendication 3,
le module de surveillance de perturbation de bande (1224) présentant un filtre (1224A) pour isoler les plages de fréquence déterminées, et
le filtre (1124A) étant au moins un filtre passe-bande et/ou au moins un montage en redresseur haute fréquence, et le filtre (1124A) est relié au niveau de sa sortie à au moins un convertisseur analogique/numérique (1224B).

7. Station d'abonné (10 ; 30) selon l'une quelconque des revendications précédentes,
l'unité de gestion de perturbation (111; 311) étant configurée pour adapter la commande de la communication du dispositif de commande de communication (11 ; 31) par au moins l'une des mesures suivantes
signaler la perturbation (50) par un message (45 ; 46 ; 47) à au moins l'une des autres stations d'abonné (20, 30) dans le système de bus (1), et/ou
renoncer à envoyer des messages de priorité inférieure (46), et/ou
envoyer des messages de sécurité (47) de manière redondante sur un autre canal de communication ou en différé, et/ou
adapter au moins un paramètre de synchronisation de bits pour le message (45 ; 46 ; 47) en fonction de la perturbation identifiée (50), et/ou
ne pas augmenter le débit de données après la phase d'arbitrage (451, 453) pour un message CAN FD (45 ; 46; 47) bien qu'un compteur d'erreurs (121 ; 321) n'ait pas encore atteint le seuil (1211 à 121N) normalement nécessaire à cet effet, et/ou
ne pas réduire l'amplitude maximale de la tension différentielle (V_{DIFF}) pour un message LVCAN, et donc ne pas augmenter le débit de données bien qu'un compteur d'erreurs (121 ; 321) n'ait pas encore atteint le seuil prédéterminé nécessaire à cet effet.

8. Station d'abonné (10 ; 30) selon l'une quelconque des revendications précédentes, dans laquelle l'unité de gestion de perturbation (111 ; 311) est configurée pour signaler la perturbation (50) par un message (55) à au moins un capteur (61, 62) qui est relié à la station d'abonné (10; 30).

9. Station d'abonné (10 ; 30) selon l'une quelconque des revendications précédentes, comprenant en outre un compteur d'erreurs (121 ; 321) qui est configuré pour totaliser séparément pour chaque station d'abonné (10, 20, 30) du système de bus (1) ladite au moins une perturbation (50) qui est créée par l'envoi du message (45 ; 46 ; 47) par le dispositif d'émission/réception (12 ; 32).

10. Station d'abonné (10 ; 30) selon l'une quelconque des revendications précédentes, comprenant en outre un compteur d'erreurs de réception (121A) et un compteur d'erreurs d'émission (121B) qui sont incrémentés ou décrémentés en fonction du type de la perturbation et/ou l'occurrence chronologique de l'envoi du message (45 ; 46 ; 47) par le bus (40).

11. Système de bus (1), comprenant
un bus (40), et
au moins deux stations d'abonné (10, 30) selon l'une quelconque des revendications précédentes qui sont reliées les unes aux autres par le bus (40) de façon à pouvoir communiquer les unes avec les autres.

12. Système de bus (1) selon la revendication 11, dans lequel les au moins deux stations d'abonné (10, 30) sont configurées pour envoyer des données (57) concernant la perturbation (50) à une centrale (8) pour une utilisation sur une carte (80) qui représente géographiquement la charge CEM correspondant à la perturbation (50).

13. Procédé de transmission de données dans un système de bus série (1), dans lequel au moins deux stations d'abonné (10 ; 30) sont reliées les unes aux autres par un bus (40) de façon à pouvoir communiquer les unes avec les autres, le procédé présentant les étapes consistant à
recevoir en série, par un dispositif d'émission/réception (12 ; 32) d'une des stations d'abonné (10 ; 30), un message (45 ; 46 ; 47) provenant du bus (40) qui a été crée par un dispositif de commande de communication (11; 31) de la station d'abonné (10; 30) ou de ladite au moins une autre station d'abonné (20 ; 30 ; 10) du système de bus (1) et est transmis sur le bus (40),
identifier, par une unité d'identification de perturbation (122 ; 322), une perturbation (50) lors de la transmission du message (45 ; 46 ; 47) sur le bus (40),
évaluer, par une unité de gestion de perturbation (111; 311), la perturbation (50) identifiée par l'unité d'identification de perturbation (122 ; 322) en termes de type et de degré de la perturbation (50), et
adapter une commande de la communication du dispositif de commande de communication (11 ; 31) au résultat de l'évaluation de la perturbation (50),
**caractérisé en ce que** l'unité d'identification de perturbation (122 ; 322) présente un module de surveillance de perturbation de mode commun (1223) permettant de surveiller si la tension moyenne provenant des signaux de bus différentiels (CAN_H, CAN_L) dévie d'une valeur prédéterminée plus rapidement que prédéterminé ou pendant une durée prédéterminée.
